# EUROPÄISCHE PATENTSCHRIFT

(11) **EP 2 240 681 B1**
(45) Veröffentlichungstag und Bekanntmachung des Hinweises auf die Patenterteilung: **31.08.2011**
(21) Anmeldenummer: 08870416.8
(22) Anmeldetag: 15.10.2008
(51) Int. Cl.: F02M 51/00, H01L 41/053

(54) **PIEZOAKTORMODUL UND PIEZOINJEKTOR SOWIE EIN VERFAHREN ZUR HERSTELLUNG EINES PIEZOAKTORMODULS**
PIEZOACTUATOR MODULE AND PIEZOINJECTOR AND A METHOD FOR THE PRODUCTION OF A PIEZOACTUATOR MODULE
MODULE D'ACTIONNEUR PIÉZOÉLECTRIQUE ET INJECTEUR PIÉZOÉLECTRIQUE, ET PROCÉDÉ DE FABRICATION D'UN MODULE D'ACTIONNEUR PIÉZOÉLECTRIQUE

(30) Priorität: 10.01.2008 DE 102008003838
(43) Veröffentlichungstag der Anmeldung: 20.10.2010
(73) Patentinhaber: Robert Bosch GmbH, 70442 Stuttgart (DE)
(72) Erfinder: KIONTKE, Martin, 71254 Ditzingen (DE); SCHAICH, Udo, 70378 Stuttgart (DE)
(86) Internationale Anmeldenummer: PCT/EP2008/063849
(87) Internationale Veröffentlichungsnummer: WO 2009/086955

(56) Entgegenhaltungen:
- WO-A-2005/073547
- DE-A1-102004 063 293

## Beschreibung

### Stand der Technik

Die Erfindung betrifft ein Piezoaktormodul nach den gattungsgemäßen Merkmalen des Anspruchs 1, einen Piezoinjektor nach den gattungsgemäßen Merkmalen des Anspruchs 9, sowie ein Verfahren nach den gattungsgemäßen Merkmalen des Anspruchs 10.

Es ist an sich bekannt, dass zum Aufbau eines Piezoaktors für ein zuvor erwähntes Piezoaktormodul Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt- und mengengenauen Dosierung von Kraftstoff in periodisch arbeitenden Verbrennungsmotoren verwendet werden.

Ein Piezoinjektor besteht im Wesentlichen aus einem Haltekörper und einem in dem Haltekörper angeordneten Piezoaktormodul, bestehend aus einem Kopf- und einem Fußteil sowie einem zwischen Kopf- und Fußteil angeordneten Piezoaktor aus einem oder mehreren Piezoelementen. Das Piezoaktormodul ist mit einer Düsennadel verbunden, sodass durch Anlegen oder Wegnahme einer Spannung an die Piezoelemente eine Düsenöffnung freigegeben oder verschlossen wird.

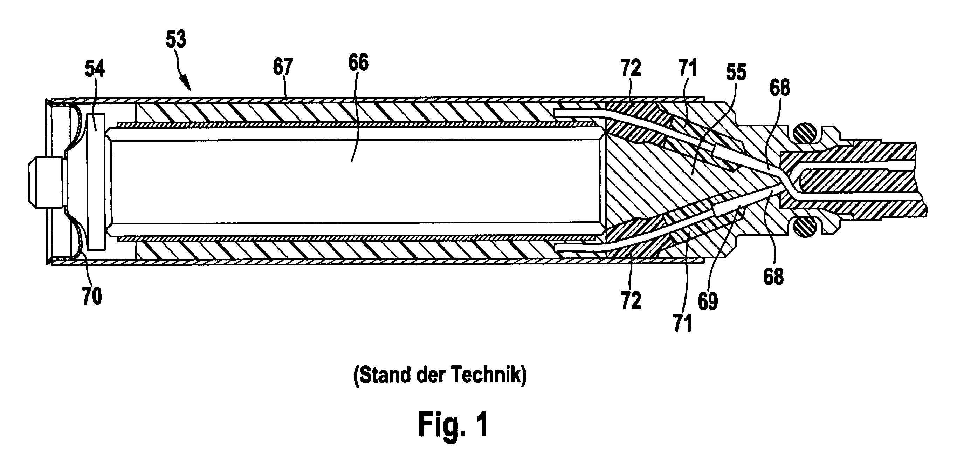

Um den Piezoaktor 66 eines in einem Piezoinjektor eingesetzten, in Fig. 1 dargestellten Piezoaktormoduls 53 gegen ein umgebendes Medium abzudichten, ist der Piezoaktor 66 in einer stabilen Metallhülse 67 gekapselt. An einer auch als aktive Stirnfläche bezeichneten Stirnfläche des Piezoaktors 66 liegt der Aktorkopf 54 auf, welcher Hub und Kraft des Piezoaktors 66 nach außen überträgt. Dieser Aktorkopf 54 ist über eine Membran 70 mit der stabilen Hülse 67 verbunden. Dabei schafft die Membran 70 eine flexible, aber dichte Verbindung zwischen Aktorkopf 54 und Hülse 67. Bei einem solchen Piezoaktormodul 53 erfolgt die elektrische Kontaktierung des Piezoaktors 66 über einen kunststoffummantelten Kupferdraht 69 der durch Durchgangsöffnungen 68 in dem aus Stahl hergestellten Aktorfuß 55 hindurchgeführt ist. Die benötigte Dichtheit der Kabeldurchführung nach innen wird innerhalb des Aktorfußes 55 mit Gummidichtbuchsen 71 erreicht. Zur Arretierung der Dichtbuchsen 71 und zur Isolierung des nicht ummantelten Kupferdrahtes 69 im Stahlteil 55 wird eine zusätzliche Kunststoffumspritzung 72 benötigt.

### Offenbarung der Erfindung

Die Erfindung geht von einem eingangs beschriebenen Piezoaktormodul zur vorzugsweise indirekten Düsennadelsteuerung aus, für eine beispielsweise mit einem flüssigen und/oder gasförmigen Medium umströmte Anordnung, insbesondere in einem Piezoinjektor. Das Piezoaktormodul besteht aus einem Aktorfuß und einem Aktorkopf und dazwischen eingefassten elektrisch kontaktierbaren bzw. kontaktierten Piezoelementen als Piezoaktor. Der Piezoaktor ist mittels durch mindestens eine mittels mindestens einer Abdichtung abgedichtete Durchgangsöffnung im Aktorfuß hindurchführende Kontaktiermittel elektrisch kontaktiert.

Erfindungsgemäß umfassen die durch die mindestens eine Durchgangsöffnung hindurchführenden Kontaktiermittel einen Lackdraht, wohingegen die Abdichtung zwischen Kontaktiermittel und der Durchgangsöffnung erfindungsgemäß eine Verstemmung bzw. mechanische Einpressung des Lackdrahtes umfasst.

Der Lackdraht, beispielsweise ein Kupfer- oder Stahllackdraht hat den Vorteil, dass er bei gleichem Leiterdurchmesser wie ein nach dem Stand der Technik konventionell mit einer Kunststoffisolierung ummantelter Draht einen geringeren Gesamtdurchmesser von vorzugsweise unter einem Millimeter aufweist und vollständig gegen den Aktorfuß isoliert und dabei eine wesentlich höhere Durchschlagfestigkeit aufweist. Eine zusätzliche Isolierung in Form einer Kunststoffummantelung ist dabei nicht notwendig. Die Lackdrähte in Form von lackierten Drähten aus vorzugsweise Kupfer oder Stahl erfüllen alle notwendigen Eigenschaften sowohl in thermischer, elektrischer, als auch mechanischer Hinsicht.

Auf Grund des im Vergleich zu konventionell mit einer Kunststoffisolierung ummanteltem Draht geringeren Gesamtdurchmessers ergeben sich zusätzliche Freiheiten bei der Gestaltung des Aktorfußes. So können durch die einhergehende Verringerung des Durchmessers der zur Durchführung des Drahts durch den Aktorfuß erforderlichen Durchgangsbohrungen weitere Optimierungen vorgenommen werden. So kann beispielsweise die Auflagefläche, auf der sich der Piezoaktor am Aktorfuß aufstützt, vergrößert werden. Dadurch verbessert sich sowohl die Belastbarkeit, als auch die Lebensdauer des Piezoaktormoduls, da nunmehr die komplette Stirnfläche des Piezoaktors auf dem Aktorfuß aufsteht. Beispielsweise zu Keramikbrüchen führende, unerwünschte Kraft- bzw. Spannungssprünge innerhalb der Kristallstruktur der Piezolagen, wie sie beim Stand der Technik aufgrund nicht vollflächiger Auflage der Stirnfläche des Piezoaktors am Aktorfuß auftreten können, können so vermieden werden. Ein weiterer positiver Effekt ist die Steigerung der Steifigkeit des Aktorfußes durch die im Vergleich zum Stand der Technik verkleinerten Durchgangsbohrungen. Dies beeinflusst die Steifigkeitskette des Piezoinjektors ebenfalls positiv.

Wichtig ist hervorzuheben, dass in jedem Fall durch den frei werdenden Bauraum erhöhte Gestaltungsmöglichkeiten zur Verfügung stehen.

Mit der Verstemmung bzw. mechanischen Einpressung des Lackdrahtes wird eine Abdichtung des Lackdrahtes nach innen erreicht. Durch die Verstemmung bzw. mechanische Einpressung des Lackdrahtes entsteht dabei sowohl ein Druck auf den Lackdraht, als auch gegen die Wandung der Durchgangsbohrung im Aktorfuß, wodurch die benötigte Dichtwirkung erreicht wird.

Vorteile der Erfindung gegenüber dem Stand der Technik ergeben sich durch eine kostengünstige und robuste Isolierung und Abdichtung der elektrischen Leitungen zur elektrischen Kontaktierung eines Piezoaktors eines Piezoaktormoduls. Diese Vorteile ergeben sich insbesondere dadurch, dass die aufwändige und kostenintensive Abdichtung der Kabeldurchführung nach dem Stand der Technik durch einen einfacheren erfindungsgemäßen Aufbau ersetzt werden kann. Durch den erfindungsgemäßen Aufbau der Kabeldurchführung entfallen die nach dem Stand der Technik erforderlichen Dichtbuchsen sowie die Umspritzung vollständig, wodurch außerdem eine höhere Fertigungsqualität erreicht wird, da deren Verwendung mit Risiken verbunden ist. So kann beispielsweise die Kunststoffumspritzung aufgrund ihres gegenüber Stahl deutlich höheren Wärmeausdehnungskoeffizienten, den Wechselwirkungen ihrer Inhaltsstoffe und der Wasseraufnahme zu unerwünschten Beeinträchtigungen und Wechselwirkungen innerhalb des Piezoaktormoduls führen.

Eine vorteilhafte Ausgestaltung der Erfindung sieht vor, dass die Verstemmung bzw. mechanische Einpressung des Lackdrahtes eine Hülse umfasst.

Die Hülse kann beispielsweise konisch oder ballig ausgebildet sein. Grundsätzlich sind auch andere Ausgestaltungen bzw. Lösungsmöglichkeiten für die Hülse denkbar.

Die Hülse ist vorzugsweise mit Hilfe von Druck in den Aktorfuß eingebracht. Aufgrund der vorzugsweise konischen Formgebung bzw. Ausbildung der Hülse entsteht dabei sowohl ein Druck auf den Lackdraht, als auch gegen die Wandung der Druckgangsbohrung im Aktorfuß, wodurch die benötigte Dichtwirkung erreicht wird.

Eine andere vorteilhafte Ausgestaltung der Erfindung sieht vor, dass die Hülse aus einem elektrisch nichtleitenden Material besteht, um auch bei einer möglichen Beschädigung der isolierenden Lackschicht die notwendige Durchschlagfestigkeit aufrecht zu halten.

Bei dem Lackdraht handelt es sich vorzugsweise um einen Kupfer- oder Stahllackdraht.

Ein zweiter Gegenstand der Erfindung betrifft einen Piezoinjektor umfassend einen Haltekörper und ein in dem Haltekörper angeordnetes Piezoaktormodul. Bei dem Piezoaktormodul handelt es sich erfindungsgemäß um ein zuvor beschriebenes Piezoaktormodul.

Ein dritter Gegenstand der Erfindung betrifft ein Verfahren zur Herstellung eines einen Aktorfuß und einen Aktorkopf und mindestens einen dazwischen eingefassten Piezoaktor aus elektrisch kontaktierbaren bzw. kontaktierten Piezoelementen umfassenden Piezoaktormoduls, bei dem der Piezoaktor mittels durch mindestens eine mittels mindestens einer Abdichtung abgedichtete Durchgangsöffnung im Aktorfuß hindurchführende Kontaktiermittel elektrisch kontaktiert ist. Das Verfahren umfasst die Verfahrensschritte:
- Durchführung mindestens eines Lackdrahtes als Kontaktiermittel durch die mindestens eine Durchgangsöffnung, sowie
- Verstemmen bzw. mechanisches Einpressen des Lackdrahtes in die Durchgangsöffnung, um eine Abdichtung des Lackdrahtes nach innen zu erreichen. Durch die Verstemmung bzw. mechanische Einpressung des Lackdrahtes entsteht dabei sowohl ein Druck auf den Lackdraht, als auch gegen die Wandung der Durchangsbohrung im Aktorfuß, wodurch die benötigte Dichtwirkung erreicht wird.

Eine vorteilhafte Ausgestaltung des erfindungsgemäßen Verfahrens sieht vor, dass zum Verstemmen bzw. mechanischen Einpressen des Lackdrahtes in die Durchgangsöffnung eine vorzugsweise konisch ausgebildete Hülse mit Hilfe von Druck in den Aktorfuß eingebracht wird. Aufgrund der konischen Formgebung bzw. Ausbildung entsteht dabei sowohl ein Druck auf den Lackdraht, als auch gegen die Wandung der Druckgangsbohrung im Aktorfuß, wodurch die benötigte Dichtwirkung erreicht wird.

### Kurze Beschreibung der Zeichnung

Ein Ausführungsbeispiel der Erfindung ist im Folgenden näher beschrieben. Es zeigen:
- Fig. 1: eine schematische Darstellung eines Piezoaktormoduls nach dem Stand der Technik in einem Längsschnitt.
- Fig. 2: eine schematische Darstellung eines Piezoinjektors nach dem Stand der Technik in einem Längsschnitt.
- Fig. 3: eine schematische Darstellung eines erfindungsgemäßen Piezoaktormoduls in einem Längsschnitt.
- Fig. 4: eine schematische Darstellung eines Lackdrahtes.
- Fig. 5: eine Detaildarstellung einer Abdichtung zwischen Lackdraht und Durchgangsöffnung mittels einer Hülse.
- Fig. 6: verschiedene Ausführungsbeispiele von Hülsen.

### Ausführungsform der Erfindung

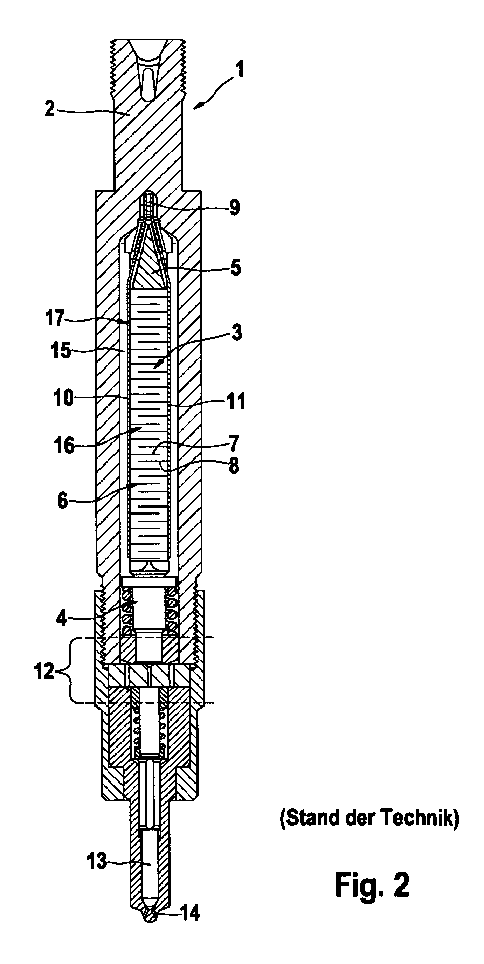

Ein in Fig. 2 zur Erläuterung des Funktionsprinzips schematisch dargestellter Piezoinjektor 01 mit direkter Nadelsteuerung umfasst im Wesentlichen einen Haltekörper 02 und ein in dem Haltekörper 02 angeordnetes Piezoaktormodul 03, das unter anderem einen Aktorkopf 04 und einen Aktorfuß 05, sowie mindestens einen zwischen dem Aktorkopf 04 und dem Aktorfuß 05 angeordneten, aus mehreren übereinander gestapelten Piezoelementen 06 bestehenden Piezoaktor 16 aufweist. Die Piezoelemente 06 bestehen jeweils aus Piezolagen aus Piezokeramik und diese einschließende Innenelektroden 07 und 08.

Die Innenelektroden 07 und 08 der Piezoelemente 06 sind mit Außenelektroden 10 und 11 und dann über ein Steckerteil 09 elektrisch kontaktiert. Das Piezoaktormodul 03 ist über einen Koppler 12 mit einer Düsennadel 13 verbunden. Durch Anlegen einer Spannung an die Piezoelemente 06 über die Innenelektroden 07 und 08 und die daraus folgende mechanische Reaktion wird, wie in der Beschreibungseinleitung erläutert, eine Düsenöffnung 14 freigegeben. Das Piezoaktormodul 03 wird bei der dargestellten Anwendung nach Fig. 2 als Piezoinjektor 01 in einem Raum 15 von einem mit dem Piezoinjektor 01 zu dosierenden Medium, typischerweise einem Kraftstoff für einen Verbrennungsmotor, umströmt.

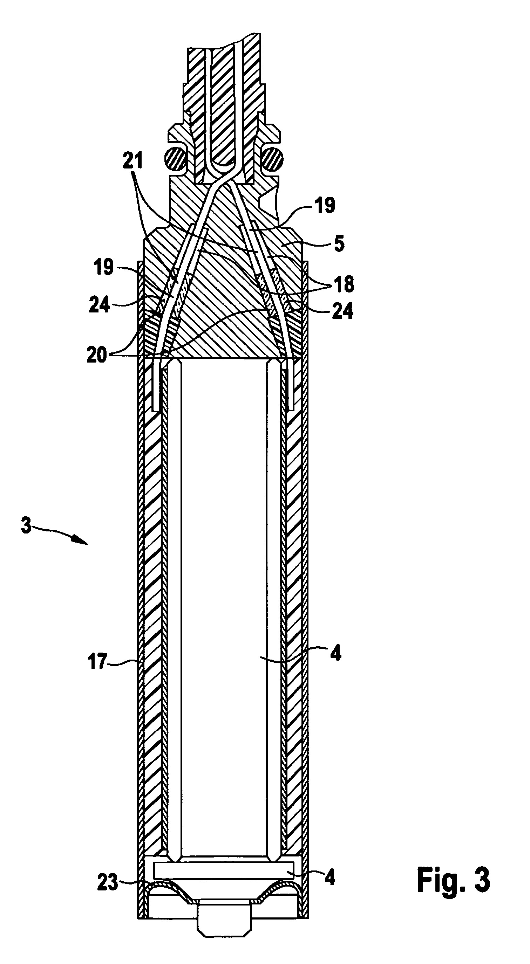

Das Piezoaktormodul 03 gemäß der Erfindung, das im Gegensatz zu dem vorher erläuterten Piezoinjektor 01 mit indirekter Nadelsteuerung arbeitet, ist in Fig. 3 im Detail dargestellt. Der Piezoaktor 16 ist vorzugsweise durch eine den Piezoaktor 16 des Piezoaktormoduls 03 gegen den Kraftstoff im Raum 15 abdichtende bzw. eine den Piezoaktor 16 vor schädlichen Bestandteilen des Kraftstoffs, wie etwa Wasser, RME oder sonstigen elektrisch leitenden Substanzen schützende Metallhülse 17 gekapselt. An einer auch als aktive Stirnfläche bezeichneten Stirnfläche des Piezoaktors 16 liegt der Aktorkopf 04 auf, welcher Hub und Kraft des Piezoaktors 16 nach außen überträgt. Der Aktorkopf 04 ist über eine Membran 23 mit der stabilen Metallhülse 17 verbunden. Dabei schafft die Membran 23 eine flexible, aber dichte Verbindung zwischen Aktorkopf 04 und Metallhülse 17.

Um die nach dem Stand der Technik erforderlichen Dichtbuchsen 71 (Fig. 1) entfallen zu lassen, wird ein System benötigt, dass die eingangs genannten, von den Dichtbuchsen 71 erfüllten Aufgaben, wie etwa eine Abdichtung nach innen sowie eine Isolierung von Kontaktiermitteln 69 in Form elektrischer Leiter bzw. Leitungen, wie etwa des Kupferdrahtes 69 gegenüber dem Stahl des Aktorfußes 55 übernimmt.

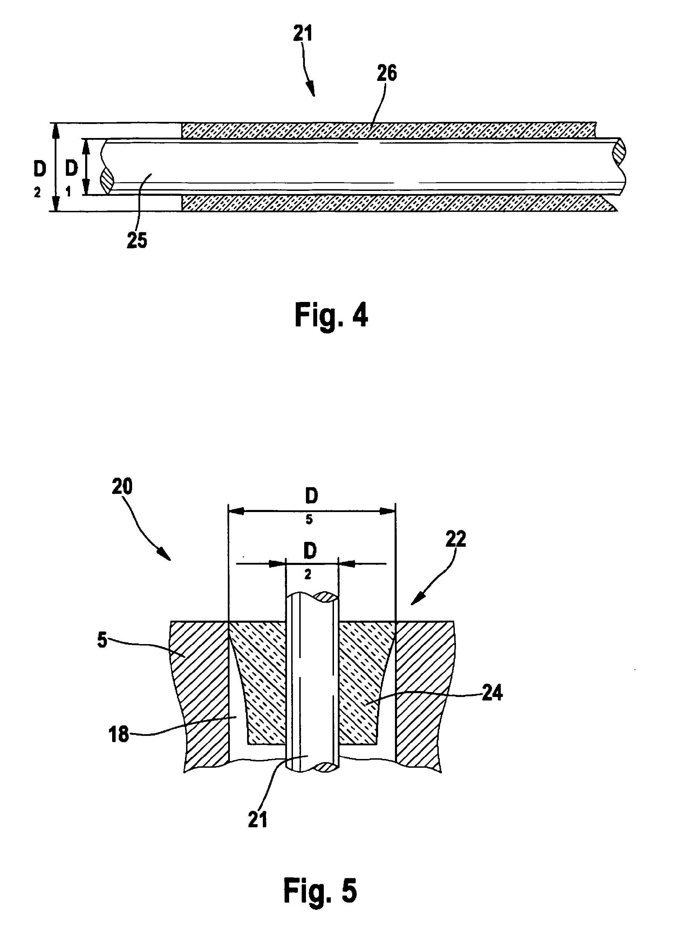

Zu diesem Zweck wird erfindungsgemäß der konventionell mit einer Kunststoffisolierung ummantelte Draht, beispielsweise der Kupferdraht 69 oder ein Stahldraht, durch ein Kontaktiermittel 19 in Form eines in Fig. 4 dargestellten Lackdrahts 21, beispielsweise einen Kupfer- oder Stahllackdraht ersetzt. Der Lackdraht 21 besteht aus einem Leiter 25 in Form beispielsweise eines Kupfer- oder Stahldrahts und einer den Leiter 25 ummantelnden Lackschicht 26. Der Lackdraht 21 hat den Vorteil, dass er bei gleichem Leiterdurchmesser D₁ wie der konventionell mit einer Kunststoffisolierung ummantelte Draht, beispielsweise von 0,5 mm, einen geringeren Gesamtdurchmesser D₂ von vorzugsweise unter einem Millimeter, beispielsweise von 0,6 mm aufweist und vollständig gegen den Aktorfuß 05 isoliert und dabei eine wesentlich höhere Durchschlagfestigkeit aufweist. Eine zusätzliche Isolierung in Form einer Kunststoffummantelung 72 (Fig. 1) ist dabei nicht notwendig. Die lackierten Drähte 21 aus vorzugsweise Kupfer oder Stahl erfüllen alle notwendigen Eigenschaften sowohl in thermischer, elektrischer, als auch mechanischer Hinsicht.

Auf Grund des im Vergleich zu konventionell mit einer Kunststoffisolierung ummanteltem Draht geringeren Gesamtdurchmessers D₂ ergeben sich zusätzliche Freiheiten bei der Gestaltung des Aktorfußes 05. So können durch die einhergehende Verringerung des Durchmessers der zur Durchführung des Drahts durch den Aktorfuß 05 erforderlichen Durchgangsöffnungen 18 in Form von beispielsweise Durchgangsbohrungen 18 weitere Optimierungen vorgenommen werden. So kann beispielsweise die Auflagefläche, auf der sich der Piezoaktor 16 am Aktorfuß 05 aufstützt, vergrößert werden. Dadurch verbessert sich sowohl die Belastbarkeit, als auch die Lebensdauer des Piezoaktormoduls 03, da nunmehr die komplette Stirnfläche des Piezoaktors 16 auf dem Aktorfuß 05 aufsteht. Beispielsweise zu Keramikbrüchen führende, unerwünschte Kraft- bzw. Spannungssprünge innerhalb der Kristallstruktur der Piezolagen bzw. Piezoelemente 06, wie sie beim Stand der Technik aufgrund nicht vollflächiger Auflage der Stirnfläche des Piezoaktors 66 am Aktorfuß 55 (Fig. 1) auftreten können, können so vermieden werden. Ein weiterer positiver Effekt ist die Steigerung der Steifigkeit des Aktorfußes 05 durch die im Vergleich zum Stand der Technik verkleinerten Durchgangsbohrungen 18. Dies beeinflusst die Steifigkeitskette des Piezoinjektors 03 ebenfalls positiv.

Wichtig ist hervorzuheben, dass in jedem Fall durch den frei werdenden Bauraum erhöhte Gestaltungsmöglichkeiten zur Verfügung stehen.

Um eine Abdichtung des Lackdrahtes 21 nach innen zu erreichen, wird vorzugsweise eine in Fig. 5 häher dargestellte Abdichtung 20 in Form einer Verstemmung 22 bzw. mechanische Einpressung des Lackdrahtes 21 beispielsweise mit einer vorzugsweise konisch ausgebildeten Hülse 24 verwendet. Diese Hülse 24 wird vorzugsweise mit Hilfe von Druck in den Aktorfuß 05 eingebracht. Aufgrund der konischen Formgebung bzw. Ausbildung entsteht dabei sowohl ein Druck auf den Gesamtdurchmesser D₂ des Lackdrahts 21, als auch gegen den Innendurchmesser D₅ bzw. die Wandung der Druckgangsbohrung 18 im Aktorfuß 05, wodurch die benötigte Dichtwirkung erreicht wird.

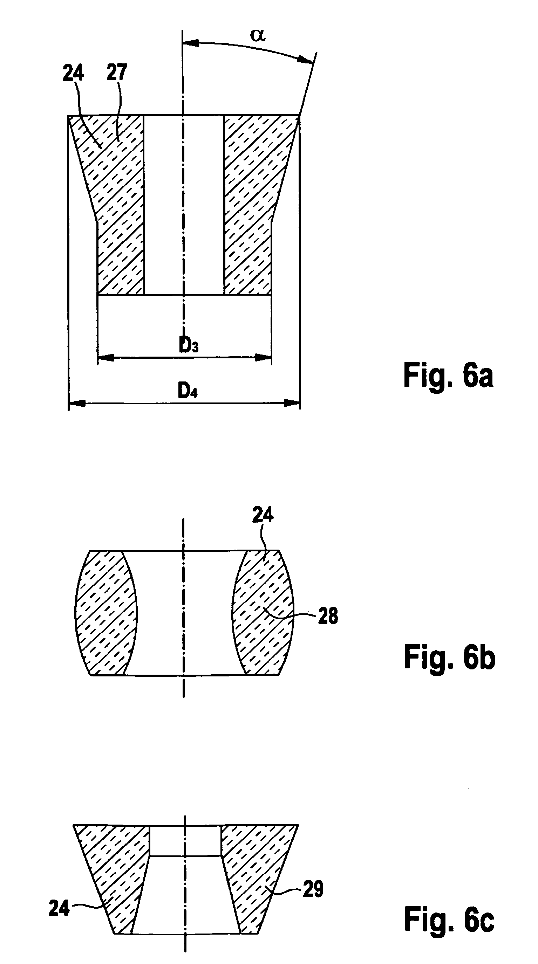

Bei der Gestaltung der Hülse 24 sind mehrere in Fig. 6 dargestellte Lösungsmöglichkeiten, wie etwa konisch oder ballig denkbar.

So weist die in Fig. 6 a) dargestellte Hülse 27, an einer ersten Stirnseite einen kleineren Außendurchmesser D₃ auf, der sich über einen konischen Abschnitt mit einem Erweiterungswinkel α auf einen größeren Außendurchmesser D₄ weitet.

Die in Fig. 6 b) dargestellte Hülse 28 weist eine ballige, torusförmige Form auf.

Die in Fig. 6 c) dargestellte Hülse 29 weist sowohl innen, als auch außen einen Konus auf.

Vorzugsweise besteht die Hülse 24 bzw. bestehen die Hülsen 24 aus einem elektrisch nichtleitenden, vorzugsweise anorganischen Material um auch bei einer möglichen Beschädigung der isolierenden Lackschicht 26 die notwendige Durchschlagfestigkeit aufrecht zu halten.

## Patentansprüche

1. Piezoaktormodul (03) mit einem Aktorfuß (05) und einem Aktorkopf (04) und mindestens einem dazwischen eingefassten Piezoaktor (16), wobei der Piezoaktor (16) mittels durch mindestens eine mittels mindestens einer Abdichtung (20) abgedichtete Durchgangsöffnung (18) im Aktorfuß (05) hindurchführende Kontaktiermittel (19) elektrisch kontaktiert ist, **dadurch gekennzeichnet, dass** die Kontaktiermittel (19) einen Lackdraht (21) umfassen und die Abdichtung (20) zwischen Kontaktiermittel (19) und der Durchgangsöffnung (18) eine Verstemmung (22) bzw. mechanische Einpressung (22) des Lackdrahtes (21) umfasst.

2. Piezoaktormodul nach Anspruch 1, **dadurch gekennzeichnet, dass** die Verstemmung (22) bzw. mechanische Einpressung des Lackdrahtes (21) eine Hülse (24, 27, 28, 29) umfasst.

3. Piezoaktormodul nach Anspruch 2, **dadurch gekennzeichnet, dass** die Hülse (24, 27, 29) konisch ausgebildet ist.

4. Piezoaktormodul nach Anspruch 2, **dadurch gekennzeichnet, dass** die Hülse (24, 28) ballig ausgebildet ist.

5. Piezoaktormodul nach Anspruch 2, 3 oder 4, **dadurch gekennzeichnet, dass** die Hülse (24, 27, 28, 29) mit Hilfe von Druck in den Aktorfuß (05) eingebracht ist.

6. Piezoaktormodul nach einem der Ansprüche 2 bis 5, **dadurch gekennzeichnet, dass** die Hülse (24, 27, 28, 29) aus einem elektrisch nichtleitenden Material besteht.

7. Piezoaktormodul nach einem der vorhergehenden Ansprüche, **dadurch gekennzeichnet, dass** es sich bei dem Lackdraht (21) um einen Kupferlackdraht handelt.

8. Piezoaktormodul nach einem der Ansprüche 1 bis 6, **dadurch gekennzeichnet, dass** es sich bei dem Lackdraht (21) um einen Stahllackdraht handelt.

9. Piezoinjektor (01) umfassend einen Haltekörper (02) und ein in dem Haltekörper (02) angeordnetes Piezoaktormodul (03), **gekennzeichnet durch** ein Piezoaktormodul (03) nach einem der Ansprüche 1 bis 8.

10. Verfahren zur Herstellung eines einen Aktorfuß (05) und einen Aktorkopf (04) und mindestens einen dazwischen eingefassten Piezoaktor (16) aus elektrisch kontaktierbaren bzw. kontaktierten Piezoelementen umfassenden Piezoaktormoduls, bei dem der Piezoaktor (16) mittels durch mindestens eine mittels mindestens einer Abdichtung (20) abgedichtete Durchgangsöffnung (18) im Aktorfuß (05) hindurchführende Kontaktiermittel (19) elektrisch kontaktiert ist, **gekennzeichnet durch** die Verfahrensschritte:
- Durchführung mindestens eines Lackdrahtes (21) als Kontaktiermittel (19) **durch** die mindestens eine Durchgangsöffnung (18), sowie
- Erzeugung einer Verstemmung (22) bzw. einer mechanischen Einpressung (22) des Lackdrahtes (21) in die Durchgangsöffnung (18).

11. Verfahren nach Anspruch 10, **dadurch gekennzeichnet, dass** zur Erzeugung einer Verstemmung (22) bzw. einer mechanischen Einpressung (22) des Lackdrahtes (21) in die Durchgangsöffnung (18) eine Hülse (24, 27, 28, 29) mit Hilfe von Druck in den Aktorfuß (05) eingebracht wird.

## Claims

1. Piezoactuator module (03) comprising an actuator base (05) and an actuator head (04) and at least one piezoactuator (16) enclosed therebetween, the piezoactuator (16) is electrically contact-connected by means of contact-connecting means (19) leading through at least one passage opening (18) in the actuator base (05), said at least one passage opening being sealed by means of at least one seal (20), **characterized in that** the contact-connecting means (19) comprise an enamelled wire (21) and a seal (20) between the contact-connecting means (19) and the passage opening (18) comprises a caulking (22) or mechanical press-fit (22) of the enamelled wire (21).

2. Piezoactuator module according to Claim 1, **characterized in that** the caulking (22) or mechanical press-fit of the enamelled wire (21) comprises a sleeve (24, 27, 28, 29).

3. Piezoactuator module according to Claim 2, **characterized in that** the sleeve (24, 27, 29) is embodied in conical fashion.

4. Piezoactuator module according to Claim 2, **characterized in that** the sleeve (24, 28) is embodied in convex fashion.

5. Piezoactuator module according to Claim 2, 3 or 4, **characterized in that** the sleeve (24, 27, 28, 29) is introduced into the actuator base (05) with the aid of pressure.

6. Piezoactuator module according to any of Claims 2 to 5, **characterized in that** the sleeve (24, 27, 28, 29) consists of an electrically non-conductive material.

7. Piezoactuator module according to any of the preceding claims, **characterized in that** the enamelled wire (21) is an enamelled copper wire.

8. Piezoactuator module according to any of Claims 1 to 6, **characterized in that** enamelled wire (21) is an enamelled steel wire.

9. Piezoinjector (01) comprising a holding body (02) and a piezoactuator module (03) arranged in the holding body (02), **characterized by** a piezoactuator module (03) according to Claims 1 to 8.

10. Method for producing a piezoactuator module comprising an actuator base (05) and an actuator head (04) and at least one piezoactuator (16) enclosed therebetween and composed of electrically contact-connectable or contact-connected piezoelements, in which the piezoactuator (16) is electrically contact-connected by means of contact-connecting means (19) leading through at least one passage opening (18) in the actuator base (05), said at least one passage opening being sealed by means of at least one seal (20), **characterized by** the following method steps:
- leading at least one enamelled wire (21) as contact-connecting means (19) through the at least one passage opening (18), and
- producing a caulking (22) or a mechanical press-fit (22) of the enamelled wire (21) into the passage opening (18).

11. Method according to Claim 10, **characterized in that**, in order to produce a caulking (22) or a mechanical press-fit (22) of the enamelled wire (21) into the passage opening (18), a sleeve (24, 27, 28, 29) is introduced into the actuator base (05) with the aid of pressure.

## Revendications

1. Module d'actionneur piézoélectrique (03) comprenant une base d'actionneur (05) et une tête d'actionneur (04) et au moins un actionneur piézoélectrique (16) encastré entre elles, l'actionneur piézoélectrique (16) étant amené en contact électrique au moyen de moyens de contact (19) guidés à travers la base d'actionneur (05) à travers au moins une ouverture de passage (18) étanchéifiée au moyen d'au moins une garniture d'étanchéité (20), **caractérisé en ce que** les moyens de contact (19) comprennent un fil laqué (21) et la garniture d'étanchéité (20) entre les moyens de contact (19) et l'ouverture de passage (18) comprend un matage (22) ou un pressage mécanique (22) du fil laqué (21).

2. Module d'actionneur piézoélectrique selon la revendication 1, **caractérisé en ce que** le matage (22) ou le pressage mécanique du fil laqué (21) comprend une douille (24, 27, 28, 29).

3. Module d'actionneur piézoélectrique selon la revendication 2, **caractérisé en ce que** la douille (24, 27, 29) est réalisée sous forme conique.

4. Module d'actionneur piézoélectrique selon la revendication 2, **caractérisé en ce que** la douille (24, 28) est réalisée sous forme bombée.

5. Module d'actionneur piézoélectrique selon la revendication 2, 3 ou 4, **caractérisé en ce que** la douille (24, 27, 28, 29) est introduite dans la base d'actionneur (05) à l'aide de pression.

6. Module d'actionneur piézoélectrique selon l'une quelconque des revendications 2 à 5, **caractérisé en ce que** la douille (24, 27, 28, 29) se compose d'un matériau non conducteur de l'électricité.

7. Module d'actionneur piézoélectrique selon l'une quelconque des revendications précédentes, **caractérisé en ce que** le fil laqué (21) est un fil de cuivre laqué.

8. Module d'actionneur piézoélectrique selon l'une quelconque des revendications 1 à 6, **caractérisé en ce que** le fil laqué (21) est un fil d'acier laqué.

9. Injecteur piézoélectrique (01) comprenant un corps de retenue (02) et un module d'actionneur piézoélectrique (03) disposé dans le corps de retenue (02), **caractérisé par** un module d'actionneur piézoélectrique (03) selon l'une quelconque des revendications 1 à 8.

10. Procédé de fabrication d'un module d'actionneur piézoélectrique comprenant une base d'actionneur (05) et une tête d'actionneur (04) et au moins un actionneur piézoélectrique (16) encastré entre elles, constitué d'éléments piézoélectriques mis ou pouvant être mis en contact électrique, l'actionneur piézoélectrique (16) étant amené en contact électrique au moyen de moyens de contact (19) guidés à travers la base d'actionneur (05) à travers au moins une ouverture de passage (18) étanchéifiée au moyen d'au moins une garniture d'étanchéité (20), **caractérisé par** les étapes de procédé suivantes :
- passage d'au moins un fil laqué (21) en tant que moyen de contact (19) à travers l'au moins une ouverture de passage (18), et
- production d'un matage (22) ou d'un pressage mécanique (22) du fil laqué (21) dans l'ouverture de passage (18).

11. Procédé selon la revendication 10, **caractérisé en ce que** pour la production d'un matage (22) ou d'un pressage mécanique (22) du fil laqué (21) dans l'ouverture de passage (18), une douille (24, 27, 28, 29) est introduite dans la base d'actionneur (05) à l'aide de pression.
